(19) **Europäisches Patentamt**
**European Patent Office**
**Office européen des brevets**

(11) **EP 4 303 872 A1**

(12) # EUROPÄISCHE PATENTANMELDUNG

(43) Veröffentlichungstag:
**10.01.2024 Patentblatt 2024/02**

(21) Anmeldenummer: **22183643.0**

(22) Anmeldetag: **07.07.2022**

(51) Internationale Patentklassifikation (IPC):
**G10L 19/038** (2013.01)   **G10L 19/008** (2013.01)
**H03M 7/30** (2006.01)   **G06F 3/01** (2006.01)

(52) Gemeinsame Patentklassifikation (CPC):
**G10L 19/038; G06F 3/016; H03M 7/3077;**
G10L 19/008

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Technische Universität München**
**80333 München (DE)**

(72) Erfinder:
• **Noll, Andreas**
  **81737 München (DE)**
• **Nockenberg, Lars Andreas**
  **80999 München (DE)**
• **Steinbach, Eckehard**
  **82140 Olching (DE)**

(74) Vertreter: **Isarpatent**
**Patent- und Rechtsanwälte Barth**
**Charles Hassa Peckmann & Partner mbB**
**Friedrichstrasse 31**
**80801 München (DE)**

(54) **KODIERUNGSVORRICHTUNG UND KODIERUNGSVERFAHREN ZUR MEHRKANALKODIERUNG VON VIBROTAKTILEN SIGNALEN SOWIE DEKODIERUNG UND DEKODIERUNGSVERFAHREN**

(57) Kodierungsvorrichtung zum Kodieren von vibrotaktilen Mehrkanalsignalen, umfassend ein Kodierer-Input-Modul, das dazu eingerichtet ist, ein Mehrkanalsignal zu empfangen; ein Transformationsmodul, das dazu ausgelegt ist, jeweils eine diskrete Wavelet-Transformation jedes Kanals des Mehrkanalsignals auszuführen und eine jeweilige Frequenzbereichsdarstellung jedes Kanals zu erzeugen; eine psychohaptische Modelleinheit, die dazu ausgebildet ist, jedem Kanal basierend auf der jeweiligen Frequenzbereichsdarstellung eine mathematische Darstellung der menschlichen Wahrnehmung des Kanals zuzuordnen; ein Clustering-Modul, das dazu eingerichtet ist, basierend auf der zugeordneten mathematischen Darstellung der menschlichen Wahrnehmung jedes Kanals und einem Ähnlichkeitsmaß der Kanäle, die Wavelettransformierten Kanäle jedes Mehrkanalsignals in Clustern zu gruppieren, wobei jedem Cluster ein Referenzkanal zugeordnet wird; ein Referenz-Kodierungsmodul, das dazu ausgebildet ist, Wavelet-Koeffizienten der Referenzkanäle, die sich aus der durchgeführten diskreten Wavelet-Transformation der Referenzkanäle ergeben, zu quantisieren und komprimieren; ein Differential-Kodierungsmodul, das dazu eingerichtet ist, die Kanäle innerhalb eines Clusters, die kein Referenzkanal sind, in Bezug auf den Referenzkanal oder mindestens einen anderen Kanal des Clusters zu kodieren; und ein Kodierer-Output-Modul, das die geclusterten, komprimierten Kanäle jedes Mehrkanalsignals als einen Bitstrom ausgibt.

Fig.1

EP 4 303 872 A1

**Beschreibung**

Technisches Gebiet der Erfindung

Die vorliegende Erfindung betrifft eine Kodierungsvorrichtung zum Kodieren von vibrotaktilen Signalen und eine Dekodierungsvorrichtung. Ferner bezieht sich die vorliegende Erfindung auf ein Verfahren zur Kodierung von vibrotaktilen Signalen und ein Dekodierungsverfahren.

Hintergrund der Erfindung

Die Kodierung und Dekodierung von haptischen Signalen, und insbesondere taktilen Signalen, ist ein Forschungsfeld, das vielfältige Anwendungen bietet, von virtueller Realität oder erweiterter Realität bis hin zum Internet of Things. Herausfordernd für alle diese Anwendungen ist eine effiziente und zuverlässige Übertragung von taktilen Wahrnehmungen.

Im Gegensatz zu optischen oder akustischen Signalen, werden taktile Signale als Vibrationen abgetastet. Die Zeitentwicklung ist deswegen eine relevante Variable. Dies führt dazu, dass die Kodierung von vibrotaktilen Signalen anders durchgeführt ist als zum Beispiel die Kodierung von Bildern mit einem JPEG Kodierer oder Musik mit einem MPEG Kodierer.

Die Datenmenge, die mit vibrotaktilen Signalen erzeugt wird, ist häufig zu groß, um eine effiziente Kodierung durchzuführen. Im Stand der Technik sind einige Methoden bekannt, um die Datenmenge vor der Kodierung effektiv zu reduzieren.

In DE 10 2019 204 527 B4 wurde eine Kodierungs- und Dekodierungsvorrichtung, zusammen mit einem Kodierungs- und Dekodierungsverfahren eingeführt, um eine effiziente Vorverarbeitung der Datenmenge zu erreichen. Die grundliegende Idee soll auf der Benutzung eines psychohaptischen Modells basieren, wodurch die Signalteile, die am wichtigsten für die menschliche Wahrnehmung sind, behalten werden sollen, während Signalteile, die nur schwer von Menschen gespürt sind, entfernt werden sollen.

Die Ideen in DE 10 2019 204 527 B4 gelten für Signale mit einem Kanal pro Signal. Es ist aber vorteilhaft, mehr als einen Kanal pro Signal zu verwalten, um mehr vibrotaktile Information zu erhalten.

Zusammenfassung der Erfindung

Es ist die Aufgabe der vorliegenden Erfindung, eine Vorrichtung und ein Verfahren bereitzustellen, die eine Kodierung und Kompression von mehrkanaligen vibrotaktilen Signalen effizient durchführen, wobei eine Reduzierung der Datenrate mit einem minimalen Verlust an relevanter Wahrnehmungsinformation erfolgt. Darüber hinaus erfüllen die Kodierungsvorrichtung und der Kodierungsverfahren die Anforderungen der wahrnehmungsbezogenen Transparenz, Modularität und Versatilität. Es ist eine weitere Aufgabe der Erfindung, eine Dekodierungsvorrichtung und ein Dekodierungsverfahren bereitzustellen, die für die Dekomprimierung von mehrkanaligen vibrotaktilen Signalen geeignet sind.

Die Aufgabe der vorliegenden Erfindung wird durch eine Kodierungsvorrichtung mit den Merkmalen des Anspruchs 1, eine Dekodierungsvorrichtung mit den Merkmalen des Anspruchs 12, ein Kodierungsverfahren mit den Merkmalen des Anspruchs 13, ein Kodierungsverfahren mit den Merkmalen des Anspruchs 14, und ein System nach Anspruch 15 gelöst. Bevorzugte Ausführungsformen der Erfindung mit vorteilhaften Merkmalen sind in den abhängigen Ansprüchen angegeben.

Nach einem ersten Aspekt der Erfindung umfasst eine Kodierungsvorrichtung zum Kodieren von vibrotaktilen Mehrkanalsignal ein Kodierer-Input-Modul, das dazu eingerichtet ist, ein Mehrkanalsignal zu empfangen; ein Transformationsmodul, das dazu ausgelegt ist, jeweils eine diskrete Wavelet-Transformation jedes Kanals des Mehrkanalsignals auszuführen und eine jeweilige Frequenzbereichsdarstellung jedes Kanals zu erzeugen; eine psychohaptische Modelleinheit, die dazu ausgebildet ist, jedem Kanal basierend auf der jeweiligen Frequenzbereichsdarstellung eine mathematische Darstellung der menschlichen Wahrnehmung des Kanals zuzuordnen; ein Clustering-Modul, das dazu eingerichtet ist, basierend auf der zugeordneten mathematischen Darstellung der menschlichen Wahrnehmung jedes Kanals und einem Ähnlichkeitsmaß der Kanäle, die Wavelet-transformierten Kanäle jedes Mehrkanalsignals in Clustern zu gruppieren, wobei jedem Cluster ein Referenzkanal zugeordnet wird; ein Referenz-Kodierungsmodul, das dazu ausgebildet ist, Wavelet-Koeffizienten der Referenzkanäle, die sich aus der durchgeführten diskreten Wavelet-Transformation der Referenzkanäle ergeben, zu quantisieren und komprimieren; ein Differential-Kodierungsmodul, das dazu eingerichtet ist, die Kanäle innerhalb eines Clusters, die kein Referenzkanal sind, in Bezug auf den Referenzkanal oder mindestens einen anderen Kanal des Clusters zu kodieren; und ein Kodierer-Output-Modul, das die geclusterten, komprimierten Kanäle jedes Mehrkanalsignals als einen Bitstrom ausgibt. In einer bevorzugten Ausführungsform ist das Differential-Kodierungsmodul dazu eingerichtet, alle Kanäle innerhalb eines Clusters, die kein Referenzkanal sind, in Bezug auf den Referenzkanal zu kodieren.

Nach einem zweiten Aspekt der Erfindung ist ein Kodierungsverfahren zur Kodierung von vibrotaktilen Mehrkanalsignalen vorgesehen, umfassend die folgenden Schritte: (a) Empfangen eines Mehrkanalsignals; (b) Ausführen einer jeweiligen diskreten Wavelet-Transformation jedes Kanals des Mehrkanalsignals; (c) Erzeugen einer jeweiligen Frequenzbereichsdarstellung jedes Kanals; (d) Zuordnen, basierend auf der Frequenzbereichsdarstellung jedes Kanals und auf einem psychohaptischen Modell, jedes Kanals einer jeweiligen mathematischen Darstellung der menschlichen Wahrnehmung des Kanals; (e) Gruppieren, basierend auf der zugeordneten mathematischen Darstellung der menschlichen Wahrnehmung jedes Kanals und auf einem Ähnlichkeitsmaß der Kanäle, der Wavelet-transformierten Kanäle jedes Mehrkanalsignals in Cluster, wobei jedem Cluster ein Referenzkanal zugeordnet wird; (f) Quantisieren und Kodieren der Wavelet-Koeffizienten der Referenzkanäle, die sich aus der durchgeführten diskreten Wavelet-Transformation der Referenzkanäle ergeben; (g) Quantisieren und Differentialkodieren der Kanäle innerhalb eines Clusters, die kein Referenzkanal sind, in Bezug auf den Referenzkanal oder einen anderen Kanal des Clusters; und (h) Ausgeben der geclusterten, komprimierten Kanäle jedes Mehrkanalsignals als einen jeweiligen Bitstrom. In einer bevorzugten Ausführungsform werden in Schritt (g) alle Kanäle innerhalb eines Clusters, die kein Referenzkanal sind, in Bezug auf den Referenzkanal differentialkodiert.

Nach einem dritten Aspekt der Erfindung umfasst eine Dekodierungsvorrichtung zum Dekodieren eines Bitstroms von geclusterten vibrotaktilen Mehrkanalsignalen, ein Dekodierer-Input-Modul, das dazu eingerichtet ist, einen Bitstrom von geclusterten vibrotaktilen Mehrkanalsignalen zu empfangen; ein Dekodierungsmodul, das dazu eingerichtet ist, den Bitstrom zu dekomprimieren und dequantisieren, ferner umfassend eine Differentialdekodierungseinheit, die dazu eingerichtet ist, die geclusterten Kanäle eines Clusters in Bezug auf einen Referenzkanal zu dekodieren; ein Declustering-Modul, das dazu ausgebildet ist, die Kanäle innerhalb eines dekodierten Clusters zu degruppieren und darauf basierend Wavelet-Koeffizienten zu bestimmen; eine inverse diskrete Wavelet-Transformationseinheit, die dazu ausgebildet ist, aus den Wavelet-Koeffizienten eines Kanals das ursprüngliche Kanal zu erzeugen; und ein Dekodierer-Output-Modul, das dazu eingerichtet ist, ein dekodiertes Mehrkanalsignal, basierend auf den dekodierten Kanälen, auszugeben.

Nach einem vierten Aspekt der Erfindung ist ein Dekodierungsverfahren zur Dekodierung eines Bitstroms von geclusterten vibrotaktilen Mehrkanalsignalen vorgesehen, umfassend die folgenden Schritten: (a) Empfangen eines Bitstroms von geclusterten vibrotaktilen Mehrkanalsignalen; (b) Dekodieren und Dequantisieren des Bitstroms, wobei durch differentialdekodieren die geclusterten Kanäle eines Clusters in Bezug auf einen Referenzkanal dekodiert werden; (c) Declustern der Kanäle innerhalb eines dekodierten Clusters, wobei die Kanäle als darauf basierend Wavelet-Koeffizienten ausgedrückt werden; (d) Ausführen einer inversen diskreten Wavelet-Transformation, wobei aus den Wavelet-Koeffizienten eines Kanals das ursprüngliche Kanal erzeugt wird; und (e) Ausgeben eines dekodierten Mehrkanalsignals, basierend auf den dekodierten Kanälen.

Insbesondere kann das Kodierungsverfahren gemäß dem zweiten Aspekt der Erfindung mit der Kodierungsvorrichtung gemäß dem ersten Aspekt der Erfindung durchgeführt werden. Die hierin im Zusammenhang mit der Kodierungsvorrichtung beschriebenen Merkmale und Vorteile sind daher auch für das Kodierungsverfahren anwendbar und umgekehrt.

In ähnlicher Weise kann das Dekodierungsverfahren gemäß dem vierten Aspekt der Erfindung mit der Dekodierungsvorrichtung gemäß dem dritten Aspekt der Erfindung durchgeführt werden. Die hierin im Zusammenhang mit der Dekodierungsvorrichtung beschriebenen Merkmale und Vorteile sind daher auch für das Dekodierungsverfahren anwendbar und umgekehrt.

Nach einem fünften Aspekt stellt die Erfindung ein Computerprogrammprodukt zur Verfügung, das einen ausführbaren Programmcode umfasst, der dazu eingerichtet ist, bei seiner Ausführung das Kodierungsverfahren gemäß dem zweiten Aspekt der vorliegenden Erfindung durchzuführen.

Nach einem sechsten Aspekt stellt die Erfindung ein Computerprogrammprodukt zur Verfügung, das einen ausführbaren Programmcode umfasst, der dazu eingerichtet ist, bei seiner Ausführung das Dekodierungsverfahren gemäß dem vierten Aspekt der vorliegenden Erfindung durchzuführen.

Nach einem siebten Aspekt stellt die Erfindung ein nicht flüchtiges computerlesbares Datenspeichermedium bereit, das einen ausführbaren Programmcode umfasst, der so konfiguriert ist, dass er bei seiner Ausführung das Verfahren gemäß dem zweiten Aspekt der vorliegenden Erfindung durchführt.

Nach einem achten Aspekt stellt die Erfindung ein nicht flüchtiges computerlesbares Datenspeichermedium bereit, das einen ausführbaren Programmcode umfasst, der so konfiguriert ist, dass er bei seiner Ausführung das Verfahren gemäß dem vierten Aspekt der vorliegenden Erfindung durchführt.

Das nicht flüchtige, computerlesbare Datenspeichermedium kann jede Art von Computerspeicher, insbesondere einen Halbleiterspeicher, wie z. B. einen Festkörperspeicher umfassen oder daraus bestehen. Das Datenspeichermedium kann auch eine CD, eine DVD, eine Blu-Ray-Disc, einen USB-Speicherstick oder dergleichen umfassen oder daraus bestehen.

Nach einem neunten Aspekt stellt die Erfindung einen Datenstrom zur Verfügung, der einen ausführbaren Programmcode umfasst oder dazu eingerichtet ist, einen solchen zu erzeugen, der dazu eingerichtet ist, bei Ausführung das Verfahren gemäß dem zweiten Aspekt der vorliegenden Erfindung durchzuführen.

Nach einem zehnten Aspekt stellt die Erfindung einen Datenstrom zur Verfügung, der einen ausführbaren Programmcode umfasst oder dazu eingerichtet ist, einen solchen zu erzeugen, der dazu eingerichtet ist, bei Ausführung das Verfahren gemäß dem vierten Aspekt der vorliegenden Erfindung durchzuführen.

Eine der Erfindung zugrundeliegende Idee besteht darin, eine Kodierungsvorrichtung für mehrkanalige vibrotaktile Signale einzuführen, in welcher die verschiedenen Kanäle, basierend auf einer Modellierung der menschlichen Wahrnehmung, geclustert sind. Die verschiedenen Cluster umfassen Kanäle, die wahrnehmungsähnlich sind. Die vibrotaktile Information der Kanäle ist damit hierarchisch angeordnet, was dazu führt, dass die relevanteste Wahrnehmungsinformation verarbeitet werden kann und die Kodierung effizient und wahrnehmungstreu ist.

Die vorstehend beschriebene Kodierungsvorrichtung ermöglicht vorteilhaft eine Implementierung eines Kodierungsverfahrens. Hierbei werden zunächst die vibrotaktilen Kanalsignale in Blöcke aufgeteilt und dann im Frequenzbereich und Wavelet-Bereich transformiert. Die Kanäle werden dann geclustert und aufgeteilt in Referenzkanäle und Nebenkanäle. Die Referenzkanäle werden kodiert und die Information in den Nebenkanäle in Bezug auf die Referenzkanäle oder anderer Kanäle desselben Clusters quantisiert und kodiert.

Ein Vorteil der vorliegenden Erfindung ist, dass die wahrnehmungsrelevante Information innerhalb der Kanäle durch das Clustering herausgehoben wird. Das trägt dazu bei, dass die Kodierung von mehrkanaligen Signalen sehr effizient durchgeführt wird.

Vorteilhafte Ausführungsformen und Weiterentwicklungen ergeben sich aus den abhängigen Ansprüchen sowie aus der Beschreibung der verschiedenen bevorzugten Ausführungsformen, die in den beigefügten Figuren dargestellt sind.

Gemäß mancher Ausführungsformen der Erfindung ist vorgesehen, dass die Kodierungsvorrichtung ferner ein Blockaufteilungsmodul umfasst, das dazu eingerichtet ist, jeden Kanal in eine Vielzahl von aufeinander folgenden Blöcken aufzuteilen.

Gemäß mancher Ausführungsformen der Erfindung ist vorgesehen, dass das Blockaufteilungsmodul eine Blockschaltereinheit umfasst, die dazu eingerichtet ist, die Länge der Blöcke zwischen einem Mindestwert BLmin und einem Höchstwert zu wählen.

Gemäß mancher Ausführungsformen der Erfindung ist vorgesehen, dass das Blockaufteilungsmodul eine Transienten-Erkennungseinheit umfasst, die dazu ausgebildet ist, die Länge der Blöcke festzulegen und der Blockschaltereinheit diese Länge zu übermitteln.

Gemäß mancher Ausführungsformen der Erfindung ist vorgesehen, dass die psychohaptische Modelleinheit dazu bereitgestellt ist, die mathematische Darstellung der menschlichen Wahrnehmung eines Kanals als eine frequenzabhängige Funktion zu erzeugen, basierend auf einer Wahrnehmungsschwelle und auf einer Maskierungsschwellenfunktion, die auf den Frequenzspitzen des Kanals basiert.

Gemäß mancher Ausführungsformen der Erfindung ist vorgesehen, dass das Clustering-Modul dazu eingerichtet ist, das Clustering von Kanälen iterativ durchzuführen, wobei es für jeden Kanal in einem Cluster mindestens einen anderen Kanal in dem Cluster gibt, zu dem das Ähnlichkeitsmaß unter einem vorbestimmten Schwellenwert liegt.

Gemäß mancher Ausführungsformen der Erfindung ist vorgesehen, dass das Ähnlichkeitsmaß zweier Kanäle proportional zu einem Energiedifferenzwert der Kanäle ist.

Gemäß mancher Ausführungsformen der Erfindung ist vorgesehen, dass der Energiedifferenzwert der Kanäle auf Basis der Wavelet-Koeffizienten der Kanäle berechnet wird.

Gemäß mancher Ausführungsformen der Erfindung ist vorgesehen, dass das Ähnlichkeitsmaß zweier Kanäle proportional zu dem Produkt der Energien der Kanäle und/oder umgekehrt proportional zu dem Produkt der Energien der Maskierungsschwellenfunktionen der Kanäle ist. In anderen Worten ist das Ähnlichkeitsmaß proportional zu dem geometrischen Durchschnitt des Signal-zu-Maskierungs-Verhältnisses (SMR).

Gemäß mancher Ausführungsformen der Erfindung ist vorgesehen, dass die Kodierungsvorrichtung ferner eine Header-Kodierungseinheit umfasst, die dazu ausgelegt ist, dem Bitstrom des kodierten Mehrkanalsignals eine Nebeninformation hinzuzufügen.

Gemäß mancher Ausführungsformen der Erfindung ist vorgesehen, dass die Kodierungsvorrichtung ferner eine Mittelwert-Kodierungseinheit umfasst, die dazu eingerichtet ist, aus einem Kanal durch Subtrahieren des Mittelwerts einen Null-Mittelwert-Kanal zu erzeugen und eine Information über den Mittelwert als eine Nebeninformation an die Header-Kodierungseinheit zu übertragen. Mittelwerte erscheinen als Null-Frequenzkomponenten im Frequenzbereich, welche dazu führen, dass die Wavelet- und Frequenz-Transformationen verzerrt wird. Es ist daher bevorzugt, die Mittelwerte der Kanäle zuerst zu subtrahieren.

Obwohl hier und auch im Folgenden einige Funktionen als von Modulen ausgeführt beschrieben werden, bedeutet dies nicht zwangsläufig, dass diese Module als voneinander getrennte Einheiten bereitgestellt werden. In Fällen, in denen ein oder mehrere Module als Software bereitgestellt werden, können die Module durch Programmcodeabschnitte oder Programmcodeschnipsel implementiert werden, die voneinander getrennt sein können, aber auch miteinander verwoben oder integriert sein können.

Ebenso können in Fällen, in denen ein oder mehrere Module als Hardware bereitgestellt werden, die Funktionen eines oder mehrerer Module durch ein und dieselbe Hardwarekomponente bereitgestellt werden oder die Funktionen mehrerer Module können auf mehrere Hardwarekomponenten verteilt sein, die nicht notwendigerweise den Modulen entsprechen müssen. Es ist daher davon auszugehen, dass jede Anwendung, jedes System, jedes Verfahren usw., das alle einem bestimmten Modul zugeschriebenen Merkmale und Funktionen aufweist, dieses Modul umfasst oder implementiert. Insbesondere ist es möglich, dass alle Module durch Programmcode implementiert werden, der von der Rechenvorrichtung, z. B. einem Server oder einer Cloud-Computing-Plattform, ausgeführt wird.

Die oben genannten Ausführungsformen und Implementierungen können beliebig miteinander kombiniert werden, soweit dies sinnvoll ist.

Der weitere Umfang der Anwendbarkeit des vorliegenden Verfahrens und der Vorrichtung wird aus den folgenden Figuren, der detaillierten Beschreibung und den Ansprüchen ersichtlich werden. Es versteht sich jedoch, dass die detaillierte Beschreibung und die spezifischen Beispiele, während sie bevorzugte Ausführungsformen der Erfindung angeben, nur zur Veranschaulichung dienen und verschiedene Änderungen und Modifikationen innerhalb des grundlegenden Gedankens und des Umfangs der Erfindung für Fachleute erkennbar sind.

Kurze Beschreibung der Zeichnungen

Nachstehend wird die Erfindung mit Bezug auf ihre vorteilhaften Ausführungsformen anhand der folgenden Zeichnungen beschrieben. Diese Zeichnungen, in denen gleiche Bezugszeichen identische oder funktionell ähnliche Elemente in den einzelnen Ansichten bezeichnen, sind zusammen mit der nachstehenden detaillierten Beschreibung in die Offenbarung aufgenommen und bilden einen Teil davon. Sie dienen dazu, Ausführungsformen von Konzepten, die die beanspruchte Erfindung beinhalten, weiter zu veranschaulichen und verschiedene Prinzipien und Vorteile dieser Ausführungsformen zu erläutern. Elementen, die in den Zeichnungen geschildert sind, sind nicht unbedingt maßgetreu dargestellt. Dies dient dazu, die Grundlagen und Prinzipien der Erfindung mit Klarheit zu offenbaren.

In den Zeichnungen:

Fig. 1 zeigt eine Kodierungsvorrichtung nach einer Ausführungsform der Erfindung;

Fig. 2 zeigt eine schematische Darstellung des Ablaufs des Algorithmus einer Blockschaltereinheit 21 nach einer Ausführungsform der Erfindung;

Fig. 3 zeigt ein schematisches Diagramm, das das Größenspektrum eines Beispielblocks, die berechneten Maskierungsschwellen, die berechnete absolute Wahrnehmungsschwelle und die daraus resultierende globale Maskierungsschwelle darstellt;

Fig. 4 zeigt ein Ablaufdiagramm des Clustering-Algorithmus nach einer Ausführungsform der Erfindung;

Fig. 5 zeigt eine beispielshafte Baumstruktur nach Anwendung des Clustering-Algorithmus, das das Clustermodul implementiert, um die Kanäle zu gruppieren;

Fig. 6 zeigt eine schematische Darstellung des Ablaufs einer Residualkodierung nach einer Ausführungsform der Erfindung;

Fig. 7 zeigt eine Dekodierungsvorrichtung zur Dekodierung mindestens eines von einem taktilen Sensor gesammelten Signals aus einem Bitstrom nach einer Ausführungsform der Erfindung;

Fig. 8 zeigt ein Flussdiagramm eines Kodierungsverfahrens zur Kodierung eines vibrotaktilen Signals gemäß einer Ausführungsform der Erfindung;

Fig. 9 zeigt ein Flussdiagramm eines beispielhaften Dekodierungsverfahrens zur Dekodierung eines vibrotaktilen Signals aus einem Bitstrom;

Fig. 10 zeigt das berechnete Signal-Rausch-Verhältnis (SNR) von Testsignalen für verschiedene Kompressionsverhältnisse (CR);

Fig. 11 vergleicht das berechnete Signal-Rausch-Verhältnis (SNR) der Testsignale für verschiedene Kompressionsverhältnisse (CR) für eine Kodierung mit und ohne Clustering;

Fig. 12 zeigt das subjektive Ähnlichkeitsmaß ST-SIM der Testsignale gegenüber den Kompressionsverhältnisse (CR); und

Fig. 13 vergleicht das subjektive Ähnlichkeitsmaß ST-SIM der Testsignale gegenüber den Kompressionsverhältnissen (CR) für eine Kodierung mit und ohne Clustering.

Fig. 14 ist ein schematisches Blockdiagramm, das ein Computerprogrammprodukt gemäß einer Ausführungsform des fünften Aspekts der vorliegenden Erfindung darstellt.

Fig. 15 ist ein schematisches Blockdiagramm, das ein Computerprogrammprodukt gemäß einer Ausführungsform des sechsten Aspekts der vorliegenden Erfindung darstellt.

Fig. 16 ist ein schematisches Blockdiagramm, das ein nicht flüchtiges computerlesbares Datenspeichermedium gemäß einer Ausführungsform des siebten Aspekts der vorliegenden Erfindung zeigt.

Fig. 17 ist ein schematisches Blockdiagramm, das ein nicht flüchtiges computerlesbares Datenspeichermedium gemäß einer Ausführungsform des achten Aspekts der vorliegenden Erfindung zeigt.

In einigen Fällen werden bekannte Strukturen und Geräte in Form von Blockdiagrammen dargestellt, um die Konzepte der vorliegenden Erfindung nicht zu verschleiern. Auch die Nummerierung der Schritte in den Verfahren soll deren Beschreibung erleichtern. Sie implizieren nicht unbedingt eine bestimmte Reihenfolge der Schritte. Insbesondere können mehrere Schritte gleichzeitig durchgeführt werden.

Beschreibung der Zeichnungen

Die ausführliche Beschreibung der voranliegenden gelisteten Zeichnungen enthält spezifische Details, um ein umfassendes Verständnis der vorliegenden Erfindung zu ermöglichen. Dem Fachmann wird jedoch klar sein, dass die vorliegende Erfindung auch ohne diese spezifischen Details ausgeführt werden kann.

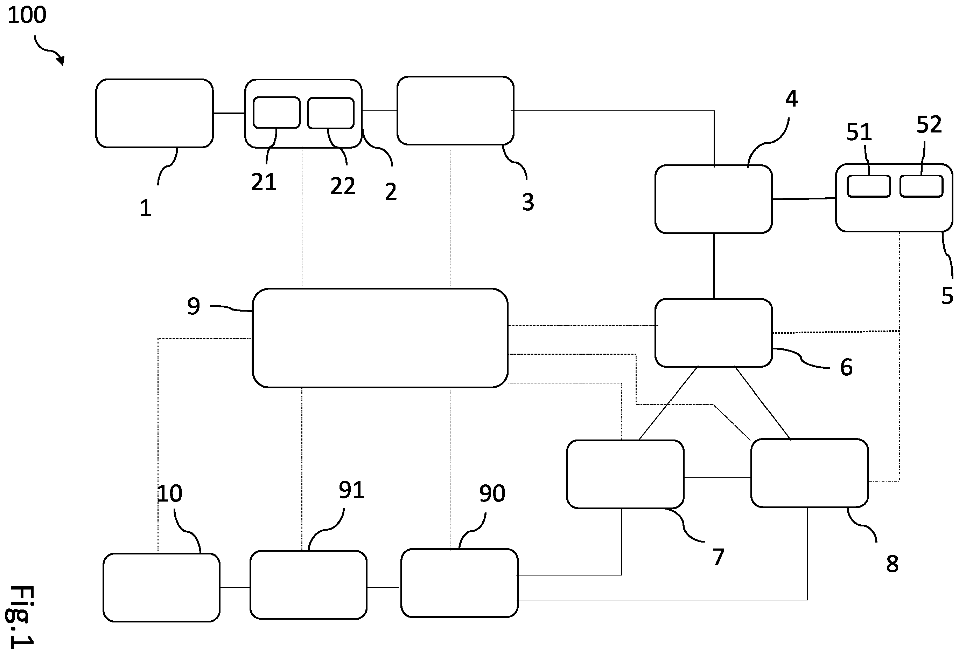

Fig. 1 zeigt eine Kodierungsvorrichtung 100 nach einer Ausführungsform der Erfindung. Die verschiedenen Bestandteile und Funktionen sind schemenhaft als Blöcke dargestellt. Die raumische Anordnung der Blöcke in Fig. 1 ist nur eine Illustration.

Je nach ihren Leistungsfunktionen können die Blöcke in Fig. 1 in drei verschiedenen Ebenen eingruppiert werden. Wie in Fig. 1 gezeigt, umfasst die Kodierungsvorrichtung 100 ein Kodierer-Input-Modul 1, ein Blockaufteilungsmodul 2 und eine Mittelwert-Kodierungseinheit 3, die zu einer Vorverarbeitungsebene gehören. Das Kodierer-Input-Modul 1 ist dazu eingerichtet, vibrotaktile Mehrkanalsignale z.B. von einem Tastsensor zu empfangen. Die vibrotaktilen Signale werden mit einer oder mehreren abgetasteten Frequenzen erzeugt, wobei mehrere Kanäle für jedes Abtastsignal zur Verfügung stehen. Das Blockaufteilungsmodul 2 ist dazu eingerichtet, jeden Kanal in eine Vielzahl von aufeinanderfolgenden Blöcken aufzuteilen. Die Aufteilung der Signale dient dazu, dass sie einfacher verarbeitet werden können.

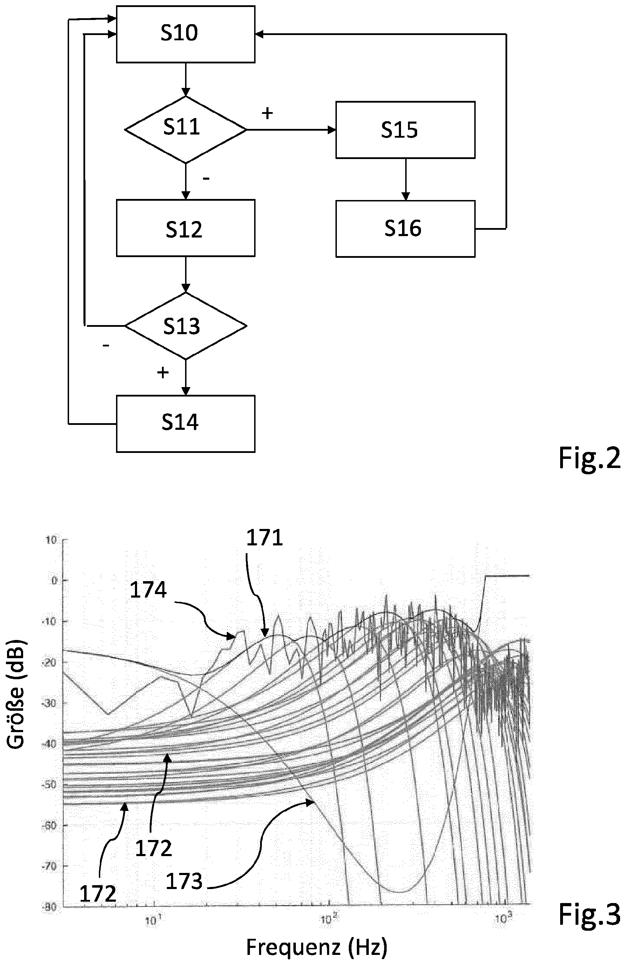

Nach manchen bevorzugten Ausführungsformen ist es vorgesehen, dass das Blockaufteilungsmodul 2 ferner eine Blockschaltereinheit 21 umfasst, welche die Länge der Blöcke festlegt zwischen einen Mindestwert BLmin und einen Höchstwert BLmax. In manchen Ausführungsformen ist es vorgesehen, die Länge der Blöcke durch eine Transienten-Erkennungseinheit 22 dynamisch festzustellen. Das Blockaufteilungsmodul 2 wird in Detail anhand von Fig. 2 beschrieben.

Die Mittelwert-Kodierungseinheit 3 dient dazu, den Mittelwert eines Signals auf Null zu setzen. Im Allgemeinen haben Signale keinen Null-Mittelwert, was zu einer signifikanten Null-Frequenzkomponente führt, wenn man das Signal im Frequenzbereich darstellt. Eine Mittelwertkomponente ungleich Null ist insbesondere bei diskreten Wavelet-Transformationen problematisch, da sie dazu führen kann, dass Wavelet-Koeffizienten unausgewogen sind. Wie nachfolgend beschrieben, skaliert die Quantisierung der Wavelet-Koeffizienten mit dem maximalen Wavelet-Koeffizienten. Daher kann ein hoher Null-Frequenz-Koeffizient dazu führen, dass die Quantisierungsskala viel gröber ist als erwünscht.

Um dieses Problem zu vermeiden, gibt es mindestens zwei Möglichkeiten. Die erste besteht darin, den Mittelwert jedes Signals zu subtrahieren, bevor es in den Codec gelangt. Dies ist besonders geeignet für Kodierungen, die keine Nullfrequenzkomponente anzeigen können. Es gibt aber auch Fälle, in welchen der Mittelwert nicht subtrahierbar ist. Die Mittelwert-Kodierungseinheit 3 ist dazu ausgebildet, den Signalmittelwert für jedes Signal zu subtrahieren und eine Quantisierung durchzuführen, so dass jedes Signal als ein Null-Mittelwert-Signal kodiert werden kann. Die Information über den Signalmittelwert wird gespeichert und schließlich mit dem Signal als einer Nebeninformation kodiert.

Der Mittelwert eines Kanalsignals $s_i$ ist mit

$$\overline{s}_i = \frac{1}{L_{block}} \sum_{n=0}^{L_{block}-1} s_i[n],$$

zu bestimmen, wobei $s_i[n]$ das Kanalsignal im Block i ist. Der höchste Mittelwert aller Kanäle ist dann quantisiert, d.h.

$$\overline{s}_{max,q} = Q\left(\max_{i \in I} \overline{s}_i\right)$$

Daraufhin werden die Mittelwerte jedes Kanals mit dem quantisierten höchsten Mittelwert normiert und dann quantisiert:

$$\overline{s}_{i,q} = Q\left(\frac{\overline{s}_i}{\overline{s}_{max,q}}\right)$$

Die subtrahierten Signale im Block i werden dann wie folgt bestimmt:

$$s_i'[n] = s_i[n] - \overline{s}_{i,q} \cdot \overline{s}_{max,q}.$$

Die Mittelwerte jeder Kanal ist damit annähernd Null.

Die Kodierungsvorrichtung 100 umfasst ferner ein Transformationsmodul 4, eine psychohaptische Modelleinheit 5, ein Clustering-Modul 6, ein Referenz-Kodierungsmodul 7 und ein Differential-Kodierungsmodul 8.

Das Transformationsmodul 4 ist dazu eingerichtet, zwei Transformationen von jedem Kanal durchzuführen: eine diskrete Wavelet-Transformation (DWT) und eine Frequenzbereichsdarstellung zu erzeugen, insbesondere durch eine diskrete Cosinus-Transformation (DCT). Die DWT stellt die Abtastsignale als eine Reihe von Wavelet-Koeffizienten dar.

Die psychohaptische Modelleinheit 5 ist dazu ausgebildet, jedem Kanal basierend auf der jeweiligen Frequenzbereichsdarstellung eine mathematische Darstellung der menschlichen haptischen, insbesondere taktilen, Wahrnehmung des Kanals zuzuordnen. In anderen Worten bewertet die psychohaptische Modelleinheit 5, basierend auf einem Wahrnehmungsmodell, jedes Signal als menschliches Wahrnehmungssignal. Die von einem Menschen wahrgenommene Berührungsempfindung ist frequenz- und amplitudenabhängig. Daher ist die Information der Frequenzbereichsdarstellung besonders relevant für das Modell. In anderen Worten zielt die psychohaptische Modelleinheit 5 darauf ab, dass Informationsverlust dort stattfindet, wo er am wenigsten wahrnehmbar ist. Die psychohaptische Modelleinheit 5 ist vorgesehen, eine Modellbereitstellungseinheit 51 und/oder eine Größenextraktionseinheit 52 umzufassen.

Die Modellbereitstellungseinheit 51 umfasst eine Spitzen(Peak)-Extraktions-Untereinheit, eine Maskierungsschwellenberechnungs-Untereinheit, eine Wahrnehmungsschwellen-Untereinheit und eine leistungsadditive Kombinations-Untereinheit. Die Peak-Extraktions-Untereinheit ist so konfiguriert, dass Peaks, d.h. Spitzen auf der Grundlage der extrahierten Größe des Signals identifiziert werden, indem Peaks identifiziert werden, die eine bestimmte Protuberanz und Höhe haben. Jeder Peak entspricht einer Frequenz $f_p$ und eine Größenordnung $a_p$. Die psychohaptische Model-leinheit besteht aus einem Speicher (nicht abgebildet), der die Frequenz $f_p$ und Größen $a_p$ jedes identifizierten Peaks speichert.

Die Maskierungsschwellenberechnungs-Untereinheit ist so konfiguriert, dass sie eine Maskierungsschwelle für die Spitzen bei verschiedenen Frequenzen f basierend auf der Frequenz $f_p$ und der Größen $a_p$ jedes Peaks sowie auf einer Abtastfrequenz $f_S$ des Signals berechnet. Die Maskierungsschwellen $m_p(f)$ bei verschiedenen Frequenzen f für jeden Peak werden mit der folgenden Gleichung berechnet:

$$m_p(f) = a_p - 5dB + 5dB \frac{2f_p}{f_s} - \frac{30dB}{f_p^2}(f - f_p)^2$$

Die Wahrnehmungsschwellen-Untereinheit ist so konfiguriert, dass sie eine absolute Wahrnehmungsschwelle bei verschiedenen Frequenzen berechnet (aufgrund der Tatsache, dass Menschen Signale bei verschiedenen Frequenzen auf unterschiedliche Weise wahrnehmen), die einer Signalgröße, insbesondere einer durchschnittlichen Signalgröße, entspricht, die der Mensch bei einer bestimmten Frequenz benötigt, um ein Signal wahrnehmen zu können. Die absoluten Wahrnehmungsschwellen t(f) bei verschiedenen Frequenzen f werden mit der folgenden Gleichung berechnet:

$$t(f) = \left| \frac{62\,dB}{\left(log_{10}\left(\frac{6}{11}\right)\right)^2} \left[log_{10}\left(\frac{f}{550\,Hz} + \frac{6}{11}\right)\right]^2 \right| - 77\,dB.$$

Die Größenextraktionseinheit 52 ist dazu eingerichtet, die Amplitude des Signals nach Durchführung der DCT zu extrahieren und das Ergebnis in dB darzustellen.

Das psychohaptische Modell beschreibt, wie der theoretische frequenzabhängige Empfindungsamplitudenschwellenwert in Abhängigkeit vom Eingangsfrequenzspektrum in einen modifizierten frequenzabhängigen Amplitudenschwellenwert modifiziert wird, der die Amplituden bei einer bestimmten Frequenz darstellt, die wirklich benötigt wird, um bei jeder Frequenz für das jeweilige betrachtete Eingangssignal eine Empfindung zu verursachen.

Die leistungsadditive Kombinations-Untereinheit ist dazu eingerichtet, einen globalen Maskierungsschwellenwert zu berechnen, basierend auf dem absoluten Wahrnehmungsschwellenwert t(f) und der Maskierungsschwelle $m_p(f)$.

Das Clustering-Modul 6 ist dazu eingerichtet, die Kanäle innerhalb eines Mehrkanalsignals die ähnlich sind, d.h. deren Information korreliert ist, zu clustern. Dies dient dazu, eine effiziente Kodierung von einem Mehrkanalsignal zu erreichen, indem die Kanäle mit redundanter Information in Clusters gruppiert werden. Erfindungsgemäß basieren die Ähnlichkeitskriterien auf einer Metrik, insbesondere auf einer wahrnehmungsempfindlichen Metrik, die mit den Energien der Wavelet-transformierten Signalen,

$$E_i := \sum_{n=0}^{L_{block}-1} w_i^2[n]$$

definiert ist. Diese Metrik definiert eine Distanz oder Ähnlichkeit zwischen zwei Kanäle i und j im Wavelet-Band b als

$$g_{i,j,b} := \frac{E_{i,j,b}^{diff}}{E_{j,b}}$$

wobei

$$E_{i,j}^{diff} := \sum_{n=0}^{L_{block}-1} (w_i[n] - w_j[n])^2,$$

Die wahrnehmungsempfindliche Metrik ist als ein gewichteter Mittelwert definiert, nämlich

$$g_{i,j} = \frac{1}{\sum_{b=1}^{B} a_b} \sum_{b=1}^{B} a_b g_{i,j,b},$$

wobei das Gewicht $a_b$

$$a_b = \sqrt{SMR_{i,b} \cdot SMR_{j,b}},$$

der geometrische Durchschnittwert des Signal-zu-Maskierungs-Verhältnisses (SMR) ist.

Vergleicht man zwei Kanäle verschiedener Cluster, so kann man feststellen, ob ihre Abweichung unter einem Schwellenwert liegen. Trifft dies zu, werden deren Cluster vereinigt.

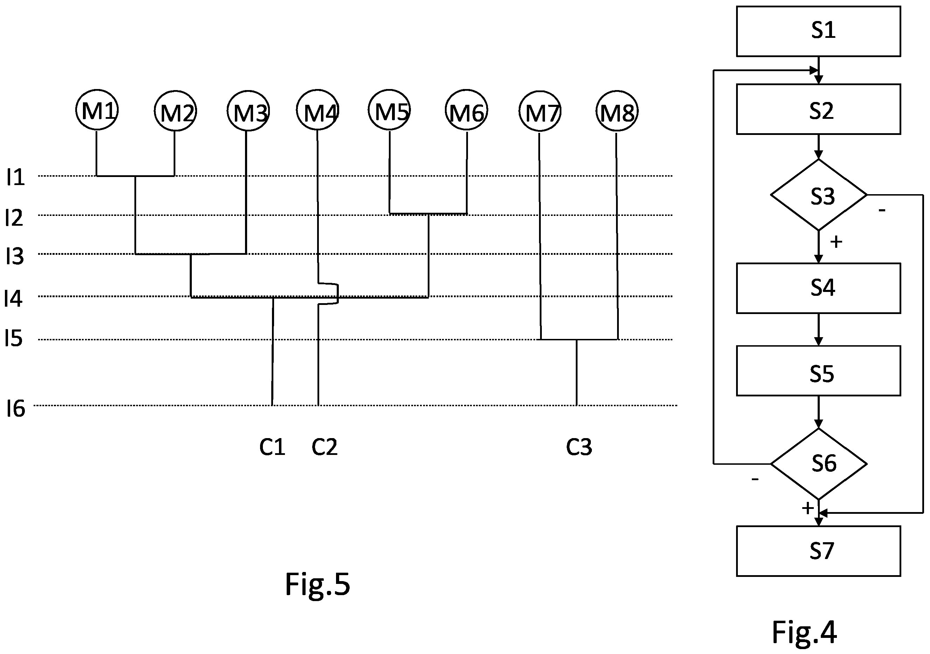

Das Clustering-Modul 6 ist ferner dazu eingerichtet, jedem Cluster einen Referenzkanal zuzuordnen. Es kann außerdem festgelegt werden, welcher andere Kanal desselben Clusters als Bezug verwendet wird, um einen Kanal, der nicht der Referenzkanal des Clusters ist, in Differential-Kodierungsmodul 8 zu kodieren. Ein Beispiel einer Anordnung von Kanälen in Clustern ist in Fig. 5 beschrieben. Das Clustering von Kanälen anhand der Metrik lässt sich als ein iteratives Verfahren implementieren. Dieses Clustering-Verfahren wird anhand von Fig. 4 beschrieben.

Das Referenz-Kodierungsmodul 7 und das Differential-Kodierungsmodul 8 sind dazu ausgebildet, die Kodierung aller Signalkanäle innerhalb eines Clusters durchzuführen.

Das Referenz-Kodierungsmodul 7 nimmt die Wavelet-Koeffizienten w des Referenzkanals eines Clusters und quantisiert sie. Die Quantisierung erfolgt beispielsweise anhand eines eingebetteten einheitlichen Quantisierers, wobei eine gesonderte Quantisierung jedes Wavelet-Bands durchgeführt wird. Innerhalb einem Wavelet-Band ist die höchste Wavelet-Koeffizienten $w_{max}$ identifiziert und quantisiert als $\hat{w}_{max}$. Mit b verfügbaren Bits ist damit die Quantisierung Schrittlänge als

$$\Delta = \frac{\hat{w}_{max}}{2^b},$$

festgestellt. Die Quantisierung der übrigen Wavelet-Koeffizienten erfolgt dann gemäß

$$\hat{w} = sgn(w) \left\lfloor \frac{w}{\Delta} \right\rfloor.$$

Jedem Wavelet-Band wird eine Bitzahl aus einem vorbestimmte Bit-Budget iterativ zugeordnet. In manchen Ausführungsformen ist es vorgesehen, nach jeder Iteration ein Bit zu dem Wavelet-Band mit der niedrigsten Auflösung anzuordnen. Die Auflösung kann beispielsweise mit dem Maskierungs-zu-Rausch-Verhältnis (MNR) berechnet werden.

Das Differential-Kodierungsmodul 8 ist dazu ausgebildet, die Kanäle innerhalb eines Clusters (außer dem Referenzkanal) in Bezug auf den Referenzkanal zu kodieren. Dies erfolgt erfindungsgemäß mit einer Differential-Kodierung. Die Wavelet-Koeffizienten jedes Kanals werden um den quantisierten Wavelet-Koeffizienten des Referenzkanals vermindert, d.h.

$$w_{res,j} = w_j - \hat{w}_i,$$

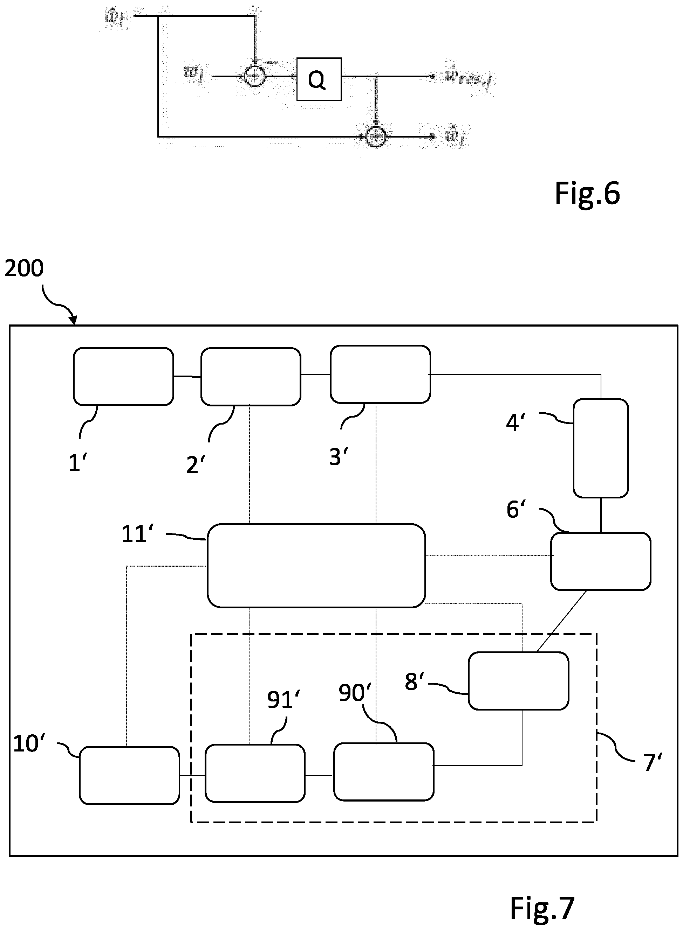

Der verminderte Wavelet-Koeffizient wird dann mit einem eingebetteten einheitlichen Quantisierer quantisiert (siehe Fig. 6), optimal mit dem eingebetteten einheitlichen Quantisierer des Referenz-Kodierungsmoduls 8.

Die zugeordnete Bitzahl eines Wavelet-Bands ist heuristisch-basiert. Anders als bei der Kodierung des Referenzkanals, das SMR ist hier kein guter Maßstab. Nach jeder Iteration bekommt ein Wavelet-Band ein gesondertes vorbestimmten Bit-Budget. Da die verminderten Wavelet-Koeffizienten sehr klein sind, modellieren die Erfinder die Verteilung des Bit-Budgets mit

$$bits_{i,b} = bits_{mean,i} + \frac{1}{2} log_2 \left( \frac{\sigma_{i,b}^2}{\sqrt[B]{\prod_{n=1}^{B} \sigma_{i,n}^2}} \right)$$

wobei

$$bits_{mean,i} = \frac{N_{bits}}{B} - log_2\left(\frac{E_i}{E_{res,i}}\right)$$

und

$$E_{res,i} := \sum_{n=0}^{L_{block}-1} w_{res,i}^2[n].$$

Das Transformationsmodul 4, die psychohaptische Modelleinheit 5, das Clustering-Modul 6, das Referenz-Kodierungsmodul 7 und das Differential-Kodierungsmodul 8 sind die Bestandteile der verlustbehafteten Kodierungsebene der Kodierungsvorrichtung 100.

Die Kodierungsvorrichtung 100 umfasst ferner eine verlustfreie Kodierungsebene. Bestandteile davon sind eine verlustfreie Kodierung, wie zum Beispiel mit einem Set-Partitioning-in-hierarchical-trees (SPIHT) Algorithmus 90, vorzugsweise zusammen mit einem Arithmetischen Kodierer (AC) 91. Der SPIHT 90 und der AC 91 komprimieren die in dem Referenz-Kodierungsmodul 7 kodierten Referenzkanäle und die in dem Differential-Kodierungsmodul 8 kodierten Nebenkanäle.

Die Kodierungsvorrichtung 100 umfasst eine Header-Kodierungseinheit 9, die dazu bereitgestellt ist, neben dem Bitstrom des kodierten Signals einen Anfangsblock hinzuzufügen, mit einer Zusatzinformation und/oder einer Nebeninformation. Diese Nebeninformation umfasst die Zahl der Kanäle und eine Block-spezifische Information. Die Block-spezifische Information umfasst die Länge der Blöcke, Details über die diskrete Wavelet-Transformation, übertragene Information aus der Mittelwert-Kodierungseinheit 3 (z.B. den quantisierten Höchstmittelwert des Signals und der anderen quantisierten Werte), und/oder eine Information über das Clustering.

Die Information über das Clustering erfolgt in zwei Schritten. In einem ersten Schritt werden die Cluster nach abnehmender Größe gelistet und die Kanäle jedes Clusters identifiziert. Wie die Information genau kodiert ist, kann besser mit einem Beispiel erklärt werden. Als Beispiel nehmen wir 8 Kanäle. Die Kodierungssequenz 01101010 würde z.B. dann ein Cluster (den größten Cluster) mit den Kanälen (2,3,5,7) beschreiben. Die aktiven Kanäle sind daher mit einer 1 gekennzeichnet, die inaktiven Kanäle (1), (4), (6), (8) mit einer 0. Dem zweitgrößten Cluster gehören die Kanäle (1,8), die unter den zuvor verbliebenen Kanälen (1), (4), (6), (8) mit 1001 beschrieben werden. Die übrigen Kanäle (4), (6) sind nicht geclustert. Diese sind mit einer 0 pro Kanal notiert. In einem zweiten Schritt sind die Referenzkanäle und die entsprechende Hierarchie der Kanäle zu notieren. Zum Beispiel wird der Cluster (2,3,5,7) in (1,2,3,4) umbenannt. Die Referenzkanäle sind mit Binärzahlen an dem Platz der Nebenkanäle zu platzieren. Wenn 4 der Referenzkanal von 1 wäre, dann würde 100 im ersten Platz eingeführt usw.

Das Kodierer-Output-Modul 10 ist dazu ausgelegt, geclusterte, komprimierte Kanäle jedes Mehrkanalsignals als einen Bitstrom auszugeben. Der Bitstrom ist ein Multiplexing Bitstrom, der die Nebeninformation, die von der Header-Kodierungseinheit 9 ausgegeben werden, zusammen mit dem Bitstrom des kodierten Signals umfasst.

Fig. 2 zeigt eine schematische Darstellung des Ablaufs des Algorithmus einer Blockschaltereinheit 21 in Zusammenhang mit einer Transienten-Erkennungseinheit 22 nach einer Ausführungsform der Erfindung. Wie schon im Voranliegenden erwähnt sind die Signale nach dem Empfangen in Blöcke unterteilt. Blöcke, die kurz sind, führen zu einem begrenzten Kompressionsverhältnis. Blöcke, die hingegen lang sind, können transiente Signale enthalten, die u.a. zu einem pre-echo Effekt führen. Idealerweise sollte die Länge der Blöcke nur beschränkt werden, wenn transiente Signale erschienen.

In einem Schritt S10 wird ein Block mit einer vorbestimmten Mindestlänge BLmin empfangen. In einem weiteren Schritt S11 wird nach transienten Signalen gesucht. Dieser Schritt kann z.B. mit einer Transienten-Erkennungseinheit durchgeführt werden. Wenn kein transientes Signal detektiert wird ( - Symbol in Fig. 2), dann wird in einem anderen Schritt S12 der Block in einem Puffer gespeichert. In einem weiteren Schritt S13 wird bestimmt, ob der Block im Puffer die Länge BLmax erreicht hat. In der ersten Iteration ist die Antwort negativ und der Algorithmus kehrt zum Schritt S10 zurück, wobei ein neuer Block von BLmin genommen und im Schritt S11 inspiziert wird. Solange kein transientes Signal anwesend ist, wird dieses Verfahren wiederholt, womit Blöcke von BLmin nebeneinander im Puffer gelegt werden.

Wenn im Schritt S13 der Puffer einen Block mit BLmax enthält, dann wird im Schritt S14 der gesamte Block mit Länge BLmax zur Kodierung geschickt, der Puffer geleert und aktualisiert. Das Verfahren fängt dann erneut mit einem neuen Block mit BLmin an.

Wenn im Schritt S11 ein transientes Signal erkannt wird (+ Symbol in Fig. 2), dann werden in einem weiteren Schritt S15 die Blöcke, die schon im Puffer sind, zur Kodierung als ein einzelner Block (mit Länge kleiner als BLmax) geschickt. Der Puffer wird geleert und aktualisiert. In einem weiteren Schritt S16 wird der Block mit dem transienten Signal zur Kodierung geschickt.

Fig. 3 zeigt ein schematisches Diagramm, das das Größenspektrum eines Beispielblocks eines Signalkanals (dargestellt mit der Linie 174) zeigt. Die horizontale Koordinatenachse die Frequenz in Hz und die vertikale Koordinatenachse bezeichnet die Größe in dB. Auch dargestellt in FIG. 3 sind die berechneten Maskierungsschwellen (dargestellt mit den Linien 172), die berechnete absolute Wahrnehmungsschwelle (dargestellt mit der Linie 173) und die daraus resultierende globale Maskierungsschwelle (dargestellt mit der Linie 171), die sich aus der logarithmischen Addition von dem Höchstwert der Maskierungsschwellen und der absoluten Wahrnehmungsschwelle ergibt.

Fig. 4 zeigt ein Ablaufdiagramm des Clustering-Algorithmus nach einer Ausführungsform der Erfindung. Als erster Schritt S1 wird das Ähnlichkeitsmaß zwischen zwei Kanälen, bevorzugt die Wahrnehmungsmetrik, für alle mögliche Kombinationen von zwei Kanälen berechnet. In einem weiteren Schritt S2 wird der Mindestwert von allen mit der Metrik berechneten Distanzen bestimmt. Als Beispiel werden zwei Kanäle beschrieben. Daraufhin wird in einem Schritt S3 dieser Mindestwert mit einem vorbestimmten Schwellenwert der Metrik verglichen. Wenn der Mindestwert größer als der Schwellenwert ist (- Symbol in Fig. 4), dann sind die Kanäle nicht ähnlich genug und kein Clustering erfolgt. Die Kanäle sind dann als einzelne Kanäle zu kodieren. In einem weiteren Schritt S7 werden die Kanäle dem Referenz-Kodierungsmodul 7 zugeschickt.

Wenn der Mindestwert kleiner als der Schwellenwert ist (+ Symbol in Fig. 4), dann werden M1 und M2 in einem weiteren Schritt S4 zusammengeclustert. In einem weiteren Schritt S5 wird einer der Kanäle, z.B. der Kanal M1, als Referenzkanal gekennzeichnet. Die Auswahl des Referenzkanals kann z.B. zufällig erfolgen. Der Kanal M2 wird als Residualkanal gekennzeichnet. Der Kanal M2 sollte nicht mehr mit anderen Kanälen verglichen werden, nur der Kanal M1, der als Referenzkanal des Clusters agiert. Daher ist die Distanz des Kanals M2 zu allen Kanälen außerhalb des Clusters unendlich groß umgesetzt. In einem weiteren Schritt S6 überprüft der Algorithmus, ob alle Kanäle geclustert sind. Wenn es nur die zwei Kanäle M1 und M2 gäbe, dann wären alle Kanäle bereits geclustert. In diesem Fall sind die Kanäle bereit zu kodieren. In einem Schritt S7 werden die geclusterten Kanäle dem Referenz-Kodierungsmodule zugeschickt. Wenn es mehr als zwei Kanäle gäbe, z.B. M1, M2, M3 und M4, dann finge der Algorithmus wiederum bei Schritt S1 an, die Distanz zwischen den Kanälen zu bewerten. In dieser zweiten Iteration werden nur die Distanzen zwischen M1, M3 und M4 berechnet. In dem Schritt S2 wird der neue Mindestwert der Distanzen bestimmt. Daraufhin wird in einem Schritt S3 dieser Mindestwert mit dem vorbestimmten Schwellenwert der Metrik verglichen, usw. Die Kanäle sind am Ende des Algorithmus in Clustern gruppiert, wobei alle die Kanäle innerhalb eines Clusters eine Distanz von ihren Referenzkanälen halten, die kleiner als der Schwellenwert ist.

Fig. 5 zeigt eine beispielshafte Baumstruktur nach Anwendung des Clustering-Algorithmus, die das Clustering-Modul 6 implementiert, um die Kanäle zu gruppieren. In diesem Beispiel gibt es acht Kanäle M1 bis M8. Nach einer ersten Iteration I1 des in der FIG. 5 beschriebenen Clustering-Algorithmus stellt sich z.B. heraus, dass M1 und M2 am nächsten liegen, mit einer Distanz unter dem Schwellenwert. Dementsprechend sind die M1 und M2 als Cluster gruppiert. M1 ist z.B. als Referenzkanal gekennzeichnet. In einer zweiten Iteration I2 liegen M5 und M6 am nächsten, mit einer Distanz unter dem Schwellenwert. Diese werden als weitere Cluster gruppiert mit z.B. M5 als Referenzkanal. In einer dritten Iteration I3 liegen M1 und M3 am nächsten, mit einer Distanz unter dem Schwellenwert. M1, M2 und M3 werden in einem Cluster gruppiert mit z.B. M1 als Referenzkanal. In einer vierten Iteration I4 liegen M1 und M5 am nächsten, mit einer Distanz unter dem Schwellenwert. Diese werden geclustert, mit z.B. M1 als Referenzkanal. In einer fünften Iteration I5 liegen M7 und M8 am nächsten, mit einer Distanz unter dem Schwellenwert. Diese werden geclustert, mit z.B. M7 als Referenzkanal. In einer sechsten Iteration I6 gibt es die Referenzkanäle M1, M4 und M7. Die Distanzen voneinander liegen über dem Schwellenwert und daher erfolgt keine weitere Gruppierung. Der Clustering-Algorithmus gruppiert die 8 Kanäle M1 bis M8 somit in 3 Cluster C1, C2, C3.

Fig. 6 zeigt eine schematische Darstellung des Ablaufs einer Kodierung der Nebenkanäle (auch als Residualkanäle gekennzeichnet) nach einer Ausführungsform der Erfindung. Wie schon im Voranstehenden erläutert, erfolgt die Kodierung eines Signalkanals durch die Quantisierung seiner Wavelet-Koeffizienten. Die Quantisierung der Wavelet-Koeffizienten eines Referenzkanals i wird durch das Referenz-Kodierungsmodul 7 durchgeführt. In Fig. 6 ist gezeigt, wie die quantisierten Wavelet-Koeffizienten des Referenzkanals i von dem Wavelet-Koeffizienten des Residualkanals j subtrahiert werden. Die subtrahierten Wavelet-Koeffizienten werden von der in dem Residual-Kodierungsmodul 8 eingebetteten Quantisierungseinheit quantisiert. Außerdem zeigt Fig. 6, wie die quantisierten Werte der Wavelet-Koeffizienten wiederhergestellt werden können durch als die Addition der quantisierten Wavelet-Koeffizienten des Referenzkanals und der quantisierten, subtrahierten Wavelet-Koeffizienten des Residualkanals. Diese Information ist für die Dekodierung, insbesondere für die Dequantisierung, relevant.

Fig. 7 zeigt eine Dekodierungsvorrichtung 200 zur Dekodierung eines von einem Tastsensor aus einem Bitstrom gesammelten vibrotaktilen Signals entsprechend einer Ausführungsform der Erfindung. Die Dekodierungsvorrichtung 200 umfasst ein Dekodierer-Input-Modul 10', ein Dekodierungsmodul 7', ein Declustering-Modul 6', eine inverse diskrete Wavelet-Transformationseinheit 4', ein Dekodierer-Output-Modul 1' und eine Header-Dekodierungseinheit 11'.

Das Dekodierer-Input-Modul 10' ist dazu eingerichtet, einen (Multiplex) Bitstrom zu empfangen und zu demultiplexieren. Nebeninformationen werden an die Header-Dekodierungseinheit 11' ausgegeben, während die kodierten Signale zur Dekodierung gesendet werden. Das Dekodierungsmodul 7' ist dazu ausgebildet, den Bitstrom zu dekomprimieren und zu dequantisieren. Dazu umfasst das Dekodierungsmodul 7' eine inverse SPIHT (ISPIHT)-Einheit 90' mit einer inversen AC-Einheit 91' und eine Differentialdekodierungseinheit 8', die dazu eingerichtet ist, die geclusterten Kanäle eines Clusters in Bezug auf einen Referenzkanal zu dekodieren. Das Declustering-Modul 6' ist dazu ausgebildet, die Kanäle innerhalb jedes Clusters zu degruppieren und die entsprechende Wavelet-Koeffizienten zu bestimmen. Die inverse diskrete Wavelet-Transformationseinheit 4' ist dazu eingerichtet, die Wavelet-Koeffizienten als Signale wiederherzustellen.

Die Dekodierungsvorrichtung 200 umfasst ferner eine Mittelwert-Dekodierungseinheit 3'und ein inverses Blockmodul 2'. Die Mittelwert-Dekodierungseinheit 3' empfängt die Nebeninformation (auch als Zusatzinformation gekennzeichnet) der Header-Dekodierungseinheit 11' und berechnet damit den angepassten Mittelwert der Signalkanäle. Das inverse Blockmodul 2' benutzt auch die Zusatzinformation, um die ursprünglichen Signalkanäle, die in Blöcke aufgeteilt waren, wieder als eine Einheit darzustellen. Das Dekodierer-Output-Modul 1' ist dazu bereitgestellt, die dekodierten Signalkanäle auszugeben.

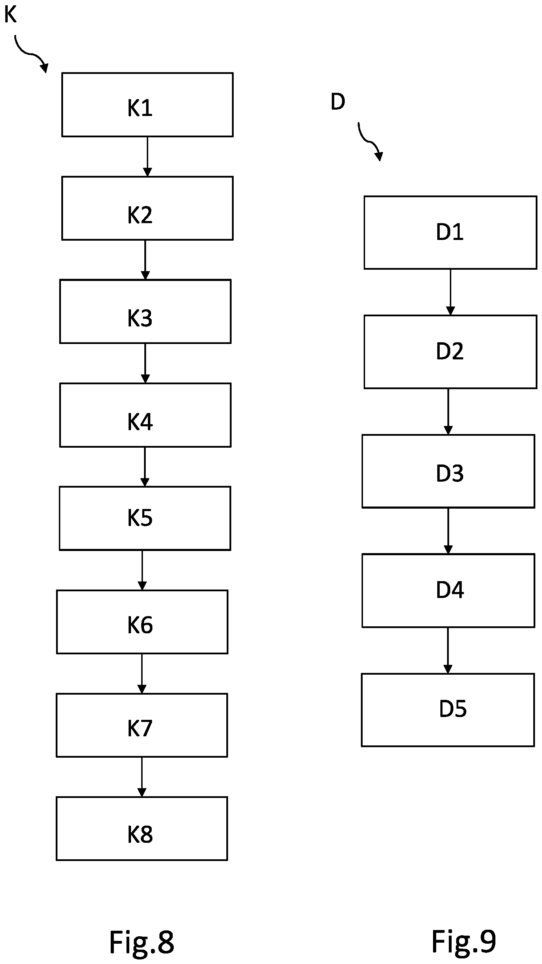

Fig. 8 zeigt ein Flussdiagramm eines Kodierungsverfahrens K zur Kodierung eines vibrotaktilen Signals gemäß einer Ausführungsform der Erfindung. In einem Schritt K1 wird ein Mehrkanalsignal empfangen. In einem weiteren Schritt K2 wird, für jeden Kanal des Mehrkanalsignals, eine jeweilige diskrete Wavelet-Transformation durchgeführt. In einem weiteren Schritt K3 wird eine Frequenzbereichsdarstellung jedes Kanals erzeugt, z.B. durch eine diskrete Cosinus-Transformation. In von den Erfindern durchgeführten Experimenten hat sich die diskrete Cosinus-Transformation als besonders stabil gezeigt. In einem weiteren Schritt K4 wird ein psychohaptisches Modell benutzt. Das Modell dient dazu, die menschliche Wahrnehmung des Mehrkanalsignals zu modellieren, um haptische Elemente in der Kodierung hinzuzufügen. Dafür verwendet das Modell die Frequenzbereichsdarstellung.

In einem weiteren Schritt K5 werden die Kanäle in Clustern gruppiert. Dies erfolgt, wie in der Fig. 4 und Fig. 5 schon beschrieben, durch einen Clustering-Algorithmus, der eine basierend auf dem psychohaptischen Modell psychohaptische Metrik oder Wahrnehmungsmetrik verwendet. Jedem Cluster wird ein Referenzkanal zugeordnet, während übrige Kanäle als Nebenkanäle verbleiben. In einem weiteren Schritt K6 werden die Wavelet-Koeffizienten der Referenzkanäle quantisiert und kodiert. In einem Schritt K7 werden die Nebenkanäle quantisiert und differentialkodiert (siehe z.B. Fig. 6 und die dazugehörige Beschreibung). In einem weiteren Schritt K8 werden die geclusterten komprimierten Kanäle als ein Bitstrom ausgegeben. Wie im Voranstehenden schon erwähnt, enthält der Bitstrom nicht nur die kodierten Signale sondern auch eine Nebeninformation, die für die Dekodierung der geclusterten Signale vonnöten ist.

Fig. 9 zeigt ein Flussdiagramm eines beispielhaften Dekodierungsverfahrens D zur Dekodierung eines vibrotaktilen Signals aus einem Bitstrom. In einem Schritt D1 wird ein (Multiplexing) Bitstrom von geclusterten vibrotaktilen Mehrkanalsignalen empfangen. In einem weiteren Schritt D2 wird der Bitstrom dekodiert und dequantisiert, wobei durch Differentialdekodieren die geclusterten Kanäle eines Clusters in Bezug auf den Referenzkanal dekodiert werden. In einem weiteren Schritt D3 werden die Kanäle innerhalb eines dekodiertes Clusters degruppiert, wobei die Kanäle als darauf basierende Wavelet-Koeffizienten bestimmt werden. In einem weiteren Schritt D4 wird eine inverse diskrete Wavelet-Transformation ausgeführt, wobei aus den Wavelet-Koeffizienten eines Kanals das ursprüngliche Kanal erzeugt wird. In einem weiteren Schritt D5 wird das dekodierte Mehrkanalsignal ausgegeben. Wie schon im Voranstehenden erläutert, ist das Dekodierungsverfahren von dem psychohaptischen Modell unabhängig. Das Verfahren kann daher für die Dekodierung von Bitströmen verwendet werden, die mit verschiedenen psychohaptischen Modellen und verschiedenen Wahrnehmungsmetriken erzeugt werden.

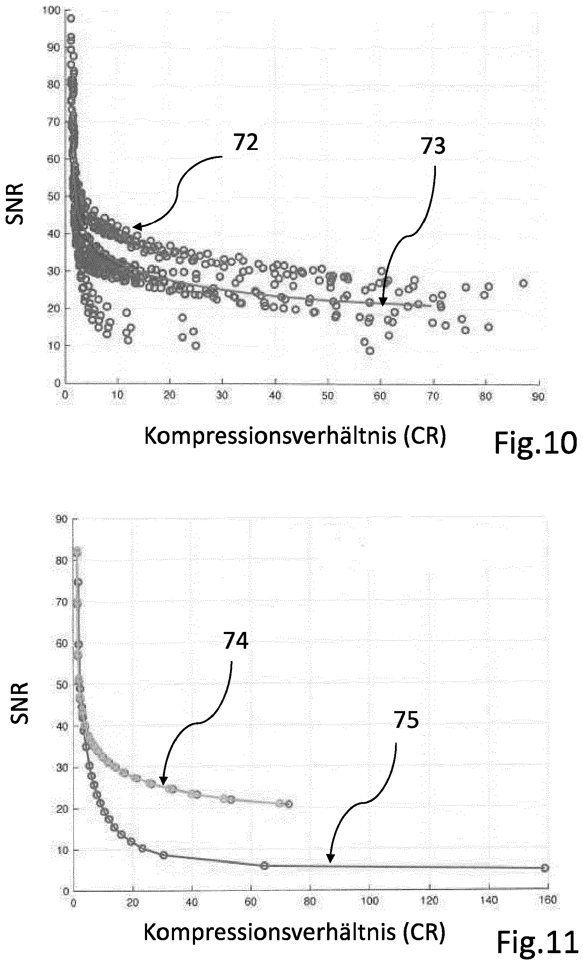

Die Graphen in Fig. 10 bis Fig. 13 belegen die Leistungsfähigkeit der erfindungsgemäßen Kodierungsvorrichtung. Zu diesem Zweck wurden zwei Gütezahlen, nämlich das Signal-Rausch-Verhältnis (SNR) und die spektral-zeitliche Ähnlichkeit (ST-SIM), für verschiedene Kompressionsverhältnisse (CR) berechnet.

Das SNR ist ein Beispiel einer objektiven Leistungszahl, welche sich hier objektiv auf das Fehlen einer Verbindung zur subjektiven menschlichen Wahrnehmung bezieht. Um die Qualität des Signals so zu bewerten, wie ein Mensch es wahrnehmen würde, werden so genannte subjektive Leistungskennzahlen eingeführt. Insbesondere die ST-SIM, welche spektrale Wahrnehmungsinformationen mit zeitlichen Ähnlichkeitsinformationen kombiniert, liefert nachweislich Ergebnisse, die die menschliche Wahrnehmung nachahmen. Die Qualitätsbewertung der Testsignale mit ST-SIM sollte daher der Qualitätsbewertung ähneln, die Menschen denselben Testsignalen zuschreiben würden.

Fig. 10 bis Fig. 13 zeigen die Ergebnisse eines durchgeführten Tests. Als Testsignale wurden 25 vibrotaktile Aufzeichnungen mit jeweils 8 Kanälen verwendet. Die Signale wurden ursprünglich mit einer Abtastfrequenz von 10Hz aufgezeichnet und dann auf 2.5Hz heruntergetastet. Der Mittelwert der Signale über alle Kanäle wurde zuvor auf 0 gesetzt und die Amplitude normiert, um einen Dynamikbereich zwischen 0 und 1 zu erhalten. Die Blocklänge wurde auf zwischen 32 und 1024 gesetzt. Das Bit-Budget jedes Blocks eines Signals wurde auf zwischen 4 und 135 Bits gesetzt. Alle Signale wurden kodiert, dekodiert und die resultierende Ausgabe dann mit dem Original verglichen.

Fig. 10 zeigt das berechnete Signal-Rausch-Verhältnis (SNR) von den 200 vibrotaktilen Testsignalen, die durch die erfindungsgemäße Kodierungsvorrichtung 100 und Dekodierungsvorrichtung 200 kodiert bzw. dekodiert wurden, für verschiedene Kompressionsverhältnisse (CR). Die Kreise 72 stellen die verschiedenen Ergebnisse dar und die Linie 73 zeigt die durchschnittlichen Leistung. Die CR-Werte liegen zwischen einem Mindestwert von 1.5 und einem Höchstwert von 87. Die durchschnittliche Leistung 73 des SNR nimmt mit steigendem CR ab, von einem Mindestwert von 27 (wenn das CR seinen Höchstwert annimmt) bis zum einem Höchstwert von circa 98 (wenn das CR seinen Mindestwert annimmt).

Fig. 11 vergleicht die Leistung der erfindungsgemäßen Kodierungsvorrichtung 100 und der erfindungsgemäßen Dekodierungsvorrichtung 200 mit einer Kodierungsvorrichtung und Dekodierungsvorrichtung nach dem Stand der Technik, mit Anwendung des SNR als Qualitätsmaßstab. Fig. 11 zeigt einerseits das berechnete Signal-Rausch-Verhältnis (SNR) 74 von den 200 vibrotaktilen Testsignalen, die durch die erfindungsgemäße Kodierungsvorrichtung 100 und Dekodierungsvorrichtung 200 kodiert und dekodiert wurden, für verschiedene Kompressionsverhältnisse (CR) und andererseits das berechnete Signal-Rausch-Verhältnis (SNR) 75 von den 200 vibrotaktilen Testsignalen, die durch eine Standard-Kodierungsvorrichtung und eine Standard-Dekodierungsvorrichtung kodiert und dekodiert wurden, für verschiedene Kompressionsverhältnisse (CR). Die erfindungsgemäßen Kodierungs- 100 und Dekodierungsvorrichtungen 200 verbessern das SNR-gegen-CR-Verhältnis im Vergleich zu der Leistung der konventionellen Kodierungs- und Dekodierungsvorrichtungen. Für Kompressionsverhältnisse ab 20 ist die Leistung um circa einen Faktor 3 verbessert.

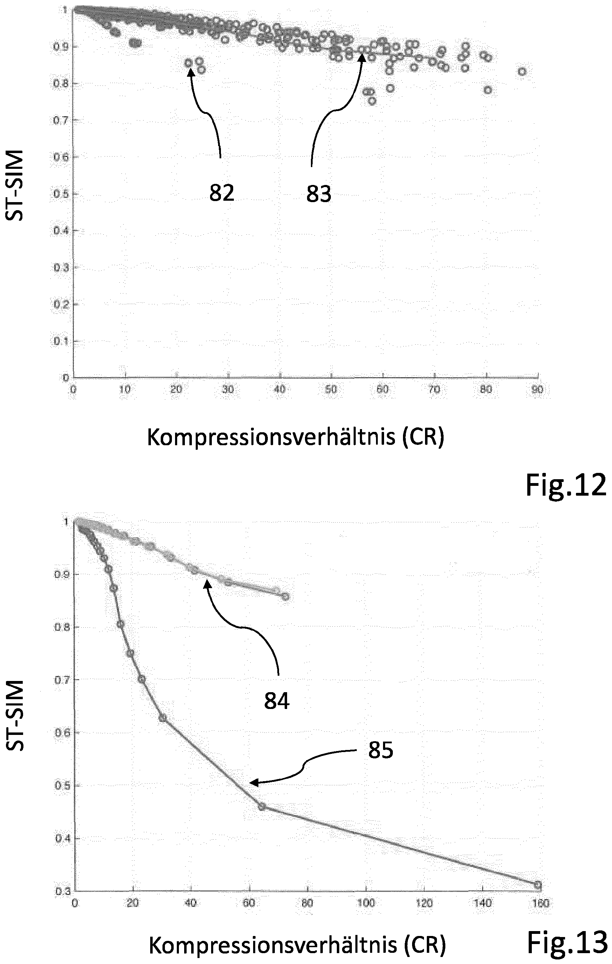

Fig. 12 zeigt das subjektive Ähnlichkeitsmaß ST-SIM der 200 Testsignale, die durch die erfindungsgemäße Kodierungsvorrichtung 100 und Dekodierungsvorrichtung 200 kodiert und dekodiert wurden, für verschiedene Kompressionsverhältnisse. Im Vergleich mit dem in Fig. 11 dargestellten SNR zeigt Fig. 12 eine höhere Qualität der Signale. Die Leistung der Codec der vorliegenden Erfindung ist für alle Testsignale über 70% und bleib verhältnismäßig flach, oder zumindest bei einer ganz milden Steigung, für hohe Kompressionsverhältnisse (z.B. bis 70). Mit anderen Worten, auch wenn die Signale hochkomprimiert sind, ist der Verlust an Signalqualität sehr gering.

Fig. 13 vergleicht die Leistung der erfindungsgemäßen Kodierungsvorrichtung 100 und der erfindungsgemäßen Dekodierungsvorrichtung 200 mit einer Kodierungsvorrichtung und Dekodierungsvorrichtung nach dem Stand der Technik, mit Anwendung des ST-SIM als Qualitätsmaßstab. Fig. 13 zeigt einerseits das berechnete ST-SIM 84 von den 200 vibrotaktilen Testsignalen, die durch die erfindungsgemäße Kodierungsvorrichtung 100 und Dekodierungsvorrichtung 200 kodiert und dekodiert wurden, für verschiedene Kompressionsverhältnisse (CR), und andererseits das berechnete ST-SIM 85 von den 200 vibrotaktilen Testsignalen, die durch eine Standard-Kodierungsvorrichtung und Standard-Dekodierungsvorrichtung kodiert und dekodiert wurden, für verschiedene Kompressionsverhältnisse (CR). Die erfindungsgemäßen Kodierungs- 100 und Dekodierungsvorrichtungen 200 zeigen eine hervorragende Leistung gegenüber dem Stand der Technik. Die Einführung einer Metrik im Clustering-Algorithmus, die Wahrnehmungsinformation beinhaltet, trägt dazu bei, dass mit der subjektiven, menschgemäßen ST-SIM die Qualität der Signale, auch für hohe Kompressionsverhältnisse, sehr hoch bleibt.

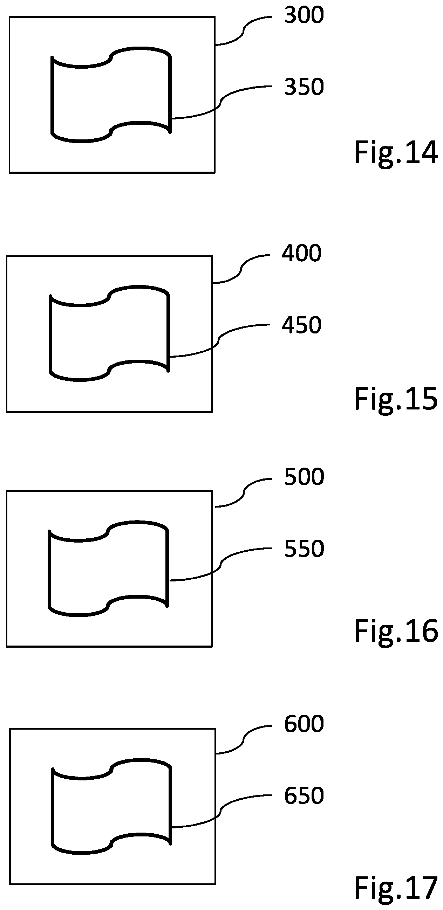

Fig. 14 zeigt ein schematisches Blockdiagramm, das ein Computerprogrammprodukt 300 gemäß einer Ausführungsform des dritten Aspekts der vorliegenden Erfindung illustriert. Das Computerprogrammprodukt 300 umfasst einen ausführbaren Programmcode 350, der so konfiguriert ist, dass er bei seiner Ausführung das Verfahren gemäß einer beliebigen Ausführungsform des zweiten Aspekts der vorliegenden Erfindung durchführt, insbesondere wie in den vorangegangenen Figuren beschrieben.

Fig. 15 zeigt ein schematisches Blockdiagramm, das ein Computerprogrammprodukt 400 gemäß einer Ausführungsform des dritten Aspekts der vorliegenden Erfindung illustriert. Das Computerprogrammprodukt 400 umfasst einen ausführbaren Programmcode 450, der so konfiguriert ist, dass er bei seiner Ausführung das Verfahren gemäß einer beliebigen Ausführungsform des vierten Aspekts der vorliegenden Erfindung durchführt, insbesondere wie in den vorangegangenen Figuren beschrieben.

Fig. 16 zeigt ein schematisches Blockdiagramm, das ein nicht flüchtiges computerlesbares Datenspeichermedium 500 gemäß einer Ausführungsform des vierten Aspekts der vorliegenden Erfindung illustriert. Das Datenspeichermedium 500 umfasst einen ausführbaren Programmcode 550, der so konfiguriert ist, dass er, wenn er ausgeführt wird, das Verfahren gemäß einer beliebigen Ausführungsform des zweiten Aspekts der vorliegenden Erfindung durchführt, insbesondere so, wie es in Bezug auf die vorhergehenden Figuren beschrieben wurde.

Fig. 17 zeigt ein schematisches Blockdiagramm, das ein nicht flüchtiges computerlesbares Datenspeichermedium 600 gemäß einer Ausführungsform des vierten Aspekts der vorliegenden Erfindung illustriert. Das Datenspeichermedium 600 umfasst einen ausführbaren Programmcode 650, der so konfiguriert ist, dass er, wenn er ausgeführt wird, das Verfahren gemäß einer beliebigen Ausführungsform des vierten Aspekts der vorliegenden Erfindung durchführt, insbesondere so, wie es in Bezug auf die vorhergehenden Figuren beschrieben wurde.

Das nicht flüchtige, computerlesbare Datenspeichermedium kann jede Art von Computerspeicher, insbesondere einen Halbleiterspeicher wie einen Festkörperspeicher, umfassen oder daraus bestehen. Das Datenspeichermedium kann auch eine CD, eine DVD, eine Blu-Ray-Disc, einen USB-Speicherstick oder ähnliches umfassen oder aus solchen bestehen.

**Patentansprüche**

1. Kodierungsvorrichtung (100) zum Kodieren von vibrotaktilen Mehrkanalsignalen, umfassend:

(a) ein Kodierer-Input-Modul (1), das dazu eingerichtet ist, ein Mehrkanalsignal zu empfangen;

(b) ein Transformationsmodul (4), das dazu ausgelegt ist, jeweils eine diskrete Wavelet-Transformation jedes Kanals des Mehrkanalsignals auszuführen und eine jeweilige Frequenzbereichsdarstellung jedes Kanals zu erzeugen;

(c) eine psychohaptische Modelleinheit (5), die dazu ausgebildet ist, jedem Kanal basierend auf der jeweiligen Frequenzbereichsdarstellung eine mathematische Darstellung der menschlichen Wahrnehmung des Kanals zuzuordnen;

(d) ein Clustering-Modul (6), das dazu eingerichtet ist, basierend auf der zugeordneten mathematischen Darstellung der menschlichen Wahrnehmung jedes Kanals und einem Ähnlichkeitsmaß der Kanäle, die Wavelet-transformierten Kanäle jedes Mehrkanalsignals in Clustern zu gruppieren, wobei jedem Cluster ein Referenzkanal zugeordnet wird;

(e) ein Referenz-Kodierungsmodul (7), das dazu ausgebildet ist, Wavelet-Koeffizienten der Referenzkanäle, die sich aus der durchgeführten diskreten Wavelet-Transformation der Referenzkanäle ergeben, zu quantisieren und komprimieren;

(f) ein Differential-Kodierungsmodul (8), das dazu eingerichtet ist, die Kanäle innerhalb eines Clusters, die kein Referenzkanal sind, in Bezug auf den Referenzkanal oder mindestens einen anderen Kanal des Clusters zu kodieren; und

(g) ein Kodierer-Output-Modul (10), das die geclusterten, komprimierten Kanäle jedes Mehrkanalsignals als einen Bitstrom ausgibt.

2. Kodierungsvorrichtung (100) nach Anspruch 1, ferner umfassend ein Blockaufteilungsmodul (2), das dazu eingerichtet ist, jeden Kanal in eine Vielzahl von aufeinander folgenden Blöcken aufzuteilen.

3. Kodierungsvorrichtung (100) nach Anspruch 2, wobei das Blockaufteilungsmodul (2) eine Blockschaltereinheit (21) umfasst, die dazu eingerichtet ist, die Länge der Blöcke zu wählen.

4. Kodierungsvorrichtung (100) nach Anspruch 3, wobei das Blockaufteilungsmodul (2) eine Transienten-Erkennungseinheit (22) umfasst, die dazu ausgebildet ist, die Länge der Blöcke festzulegen und der Blockschaltereinheit (21) diese Länge zu übermitteln.

5. Kodierungsvorrichtung (100) nach einem der Ansprüche 1 bis 4, wobei die psychohaptische Modelleinheit (5) dazu bereitgestellt ist, die mathematische Darstellung der menschlichen Wahrnehmung eines Kanals als eine frequenzabhängige Funktion zu erzeugen, basierend auf einer Wahrnehmungsschwelle und auf einer Maskierungsschwellenfunktion, die auf den Frequenzspitzen des Kanals basiert.

6. Kodierungsvorrichtung (100) nach einem der Ansprüche 1 bis 5, wobei das Clustering-Modul (6) dazu eingerichtet ist, das Clustering von Kanälen iterativ durchzuführen, wobei es für jeden Kanal in einem Cluster mindestens einen anderen Kanal in dem Cluster gibt, zu dem das Ähnlichkeitsmaß unter einem vorbestimmten Schwellenwert liegt.

7. Kodierungsvorrichtung (100) nach einem der Ansprüche 1 bis 6, wobei das Ähnlichkeitsmaß zweier Kanäle proportional zu einem Energiedifferenzwert der Kanäle ist.

8. Kodierungsvorrichtung (100) nach Anspruch 7, wobei der Energiedifferenzwert der Kanäle auf Basis der Wavelet-Koeffizienten der Kanäle berechnet wird.

9. Kodierungsvorrichtung (100) nach Anspruch 5 und einem der Ansprüche 6 bis 8, wobei das Ähnlichkeitsmaß zweier Kanäle proportional zu dem Produkt der Energien der Kanäle und/oder umgekehrt proportional zu dem Produkt der Energien der Maskierungsschwellenfunktionen der Kanäle ist.

10. Kodierungsvorrichtung (100) nach einem der Ansprüche 1 bis 9, ferner umfassend eine Header-Kodierungseinheit (9), die dazu ausgelegt ist, dem Bitstrom des kodierten Mehrkanalsignals eine Nebeninformation hinzuzufügen.

11. Kodierungsvorrichtung (100) nach Anspruch 10, ferner umfassend eine Mittelwert-Kodierungseinheit (3), die dazu eingerichtet ist, aus einem Kanal durch Subtrahieren des Mittelwerts einen Null-Mittelwert-Kanal zu erzeugen und eine Information über den Mittelwert als eine Nebeninformation an die Header-Kodierungseinheit (9) zu übertragen.

12. Dekodierungsvorrichtung (200) zum Dekodieren eines Bitstroms von geclusterten vibrotaktilen Mehrkanalsignalen, umfassend:

(a) ein Dekodierer-Input-Modul (10'), das dazu eingerichtet ist, einen Bitstrom von geclusterten vibrotaktilen Mehrkanalsignalen zu empfangen;

(b) ein Dekodierungsmodul (7'), das dazu eingerichtet ist, den Bitstrom zu dekomprimieren und dequantisieren, ferner umfassend eine Differentialdekodierungseinheit (8'), die dazu eingerichtet ist, die geclusterten Kanäle eines Clusters in Bezug auf einen Referenzkanal zu dekodieren;

(c) ein Declustering-Modul (6'), das dazu ausgebildet ist, die Kanäle innerhalb eines dekodierten Clusters zu degruppieren und darauf basierend Wavelet-Koeffizienten zu bestimmen;

(d) eine inverse diskrete Wavelet-Transformationseinheit (4'), die dazu ausgebildet ist, aus den Wavelet-Koeffizienten eines Kanals das ursprüngliche Kanal zu erzeugen; und

(e) ein Dekodierer-Output-Modul (1'), das dazu eingerichtet ist, ein dekodiertes Mehrkanalsignal, basierend auf den dekodierten Kanälen, auszugeben.

13. Kodierungsverfahren (K) zur Kodierung von vibrotaktilen Mehrkanalsignalen, insbesondere mithilfe der Kodierungsvorrichtung (100) nach einem der Ansprüche 1 bis 11, umfassend die folgenden Schritte:

(a) Empfangen (K1) eines Mehrkanalsignals;

(b) Ausführen (K2) einer jeweiligen diskreten Wavelet-Transformation jedes Kanals des Mehrkanalsignals;

(c) Erzeugen (K3) einer jeweiligen Frequenzbereichsdarstellung jedes Kanals;

(d) Zuordnen (K4), basierend auf der Frequenzbereichsdarstellung jedes Kanals und auf einem psychohaptischen Modell, jedes Kanals einer jeweiligen mathematischen Darstellung der menschlichen Wahrnehmung des Kanals;

(e) Gruppieren (K5), basierend auf der zugeordneten mathematischen Darstellung der menschlichen Wahrnehmung jedes Kanals und auf einem Ähnlichkeitsmaß der Kanäle, der Wavelet-transformierten Kanäle jedes Mehrkanalsignals in Cluster, wobei jedem Cluster ein Referenzkanal zugeordnet wird;

(f) Quantisieren und Kodieren (K6) der Wavelet-Koeffizienten der Referenzkanäle, die sich aus der durchgeführten diskreten Wavelet-Transformation der Referenzkanäle ergeben;

(g) Quantisieren und Differentialkodieren (K7) der Kanäle innerhalb eines Clusters, die kein Referenzkanal sind, in Bezug auf den Referenzkanal oder mindestens einen anderen Kanal des Clusters; und

(h) Ausgeben (K8) der geclusterten, komprimierten Kanäle jedes Mehrkanalsignals als einen jeweiligen Bitstrom.

14. Dekodierungsverfahren (D) zur Dekodierung eines Bitstroms von geclusterten vibrotaktilen Mehrkanalsignalen, insbesondere mithilfe der Dekodierungsvorrichtung (200) nach Anspruch 12, umfassend die folgenden Schritte:

(a) Empfangen (D1) eines Bitstroms von geclusterten vibrotaktilen Mehrkanalsignalen;

(b) Dekodieren und Dequantisieren (D2) des Bitstroms, wobei durch differentialdekodieren die geclusterten Kanäle eines Clusters in Bezug auf einen Referenzkanal dekodiert werden;

(c) Declustern (D3) der Kanäle innerhalb eines dekodierten Clusters, wobei die Kanäle als darauf basierend Wavelet-Koeffizienten ausgedrückt werden;

(d) Ausführen (D4) einer inversen diskreten Wavelet-Transformation, wobei aus den Wavelet-Koeffizienten eines Kanals das ursprüngliche Kanal erzeugt wird; und

(e) Ausgeben (D5) eines dekodierten Mehrkanalsignals, basierend auf den dekodierten Kanälen.

15. System zur Übertragung von vibrotaktilen Signalkanälen, umfassend eine Kodierungsvorrichtung (100) nach einem der Ansprüche 1 bis 11 und eine Dekodierungsvorrichtung (200) nach Anspruch 12, wobei die Dekodierungsvorrichtung (200) dazu ausgebildet ist, ein vibrotaktiles Signal, das mit der Kodierungsvorrichtung (100) kodiert wurde, zu dekodieren.

Es folgen 8 Seiten Zeichnungen

Fig.1

Fig.2

Fig.3

Fig.5

Fig.4

Fig.6

Fig.7

K

| K1 |
|---|

↓

| K2 |
|---|

↓

| K3 |
|---|

↓

| K4 |
|---|

↓

| K5 |
|---|

↓

| K6 |
|---|

↓

| K7 |
|---|

↓

| K8 |
|---|

Fig.8

D

| D1 |
|---|

↓

| D2 |
|---|

↓

| D3 |
|---|

↓

| D4 |
|---|

↓

| D5 |
|---|

Fig.9

Kompressionsverhältnis (CR)  Fig.10

Kompressionsverhältnis (CR)  Fig.11

Kompressionsverhältnis (CR)

Fig.12

Kompressionsverhältnis (CR)

Fig.13

Fig.14

Fig.15

Fig.16

Fig.17

Europäisches
Patentamt

European
Patent Office

Office européen
des brevets

# EUROPÄISCHER RECHERCHENBERICHT

Nummer der Anmeldung

EP 22 18 3643

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 768 780 B1 (US ROBOTICS MOBILE COMM CORP [US]) 2. Mai 2003 (2003-05-02) | 1-3,5, 10,12-15 | INV. G10L19/038 |
| Y | * Zusammenfassung; Abbildungen 1-3 * | 4,6-8 | |
| A | * Absätze [0001] – [0004], [0008], [0010], [0016] – [0018], [0036] – [0043], [0047], [0050] – [0058], [0081] – [0093], [0100], [0111] – [0115] * * Absätze [0127] – [0134], [0163] * ----- | 9,11 | ADD. G10L19/008 H03M7/30 G06F3/01 |
| A,D | DE 10 2019 204527 A1 (UNIV MUENCHEN TECH [DE]) 1. Oktober 2020 (2020-10-01) * das ganze Dokument * ----- | 1-15 | |
| Y | DE 103 28 777 A1 (CODING TECHNOLOGIES AB STOCKHO [SE]) 27. Januar 2005 (2005-01-27) * Absätze [0001], [0008] * ----- | 4 | |
| Y | Amir Ali: "Clustering(K-Mean and Hierarchical) with Practical Implementation ¦ by Amir Ali ¦ Wavy AI Research Foundation ¦ Medium", , 10. Februar 2019 (2019-02-10), Seiten 1-20, XP093021398, Gefunden im Internet: URL:https://medium.com/machine-learning-re searcher/clustering-k-mean-and-hierarchica l-cluster-fa2de08b4a4b [gefunden am 2023-02-06] | 6-8 | RECHERCHIERTE SACHGEBIETE (IPC) G10L G06T G11B H04L G06F G08B H03M |
| A | * Absatz [02.1] – Absatz [02.2] * ----- | 9 | |

Der vorliegende Recherchenbericht wurde für alle Patentansprüche erstellt

| Recherchenort | Abschlußdatum der Recherche | Prüfer |
|---|---|---|
| Den Haag | 6. Februar 2023 | Scappazzoni, E |

Europäisches
Patentamt

European
Patent Office

Office européen
des brevets

Nummer der Anmeldung

EP 22 18 3643

## GEBÜHRENPFLICHTIGE PATENTANSPRÜCHE

Die vorliegende europäische Patentanmeldung enthielt bei ihrer Einreichung Patentansprüche, für die eine Zahlung fällig war.

[ ] Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

[ ] Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

**Siehe Ergänzungsblatt B**

[X] Alle weiteren Recherchengebühren wurden innerhalb der gesetzten Frist entrichtet. Der vorliegende europäische Recherchenbericht wurde für alle Patentansprüche erstellt.

[ ] Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

[ ] Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

[ ] Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

[ ] Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt

European
Patent Office

Office européen
des brevets

**MANGELNDE EINHEITLICHKEIT
DER ERFINDUNG
ERGÄNZUNGSBLATT B**

**Nummer der Anmeldung**

**EP 22 18 3643**

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 2-5, 12-15(vollständig); 1, 10(teilweise)

    Vorrichtung zum Kodieren von vibrotaktilen Mehrkanalsignal mit einem Blockaufteilungsmodul und das Blockaufteilungsmodul umfasst eine Transienten-Erkennungseinheit.
    ---

2. Ansprüche: 6-9(vollständig); 1(teilweise)

    Der Vorrichtung umfasst zusätzliche Merkmale des Clusterings und des Ähnlichkeitsmaßes
    ---

3. Ansprüche: 11(vollständig); 1, 10(teilweise)

    Der Vorrichrung umfasst eine Mittelwert-Kodierungseinheit
    ---

**ANHANG ZUM EUROPÄISCHEN RECHERCHENBERICHT
ÜBER DIE EUROPÄISCHE PATENTANMELDUNG NR.**

EP 22 18 3643

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-02-2023

| Im Recherchenbericht angeführtes Patentdokument | Datum der Veröffentlichung | Mitglied(er) der Patentfamilie | | Datum der Veröffentlichung |
|---|---|---|---|---|
| EP 0768780 B1 | 02-05-2003 | AT | 239334 T | 15-05-2003 |
| | | AU | 6492196 A | 30-04-1997 |
| | | EP | 0768780 A2 | 16-04-1997 |
| | | IL | 119019 A | 19-03-2001 |
| | | MY | 116544 A | 28-02-2004 |
| | | TW | 351882 B | 01-02-1999 |
| | | US | 5819215 A | 06-10-1998 |
| | | US | 5845243 A | 01-12-1998 |
| | | WO | 9714138 A1 | 17-04-1997 |
| DE 102019204527 A1 | 01-10-2020 | CN | 111757127 A | 09-10-2020 |
| | | DE | 102019204527 A1 | 01-10-2020 |
| | | US | 2020312103 A1 | 01-10-2020 |
| DE 10328777 A1 | 27-01-2005 | CN | 1809872 A | 26-07-2006 |
| | | DE | 10328777 A1 | 27-01-2005 |
| | | DE | 602004005197 T2 | 28-06-2007 |
| | | EP | 1636791 A1 | 22-03-2006 |
| | | HK | 1083664 A1 | 07-07-2006 |
| | | JP | 2009513992 A | 02-04-2009 |
| | | US | 2006167683 A1 | 27-07-2006 |
| | | WO | 2005001813 A1 | 06-01-2005 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102019204527 B4